Europäisches Patentamt

European Patent Office

Office européen des brevets

(19)

(11) Publication number: **0 064 339**
**B1**

(12) # EUROPEAN PATENT SPECIFICATION

(45) Date of publication of patent specification: **22.10.86**

(51) Int. Cl.⁴: **H 01 S 3/23**

(21) Application number: **82301922.9**

(22) Date of filing: **14.04.82**

(54) **Semiconductor laser device.**

(30) Priority: **15.04.81 JP 55547/81**

(43) Date of publication of application:
**10.11.82 Bulletin 82/45**

(45) Publication of the grant of the patent:
**22.10.86 Bulletin 86/43**

(84) Designated Contracting States:
**DE FR GB NL**

(56) References cited:
**EP-A-0 010 949**
**US-A-4 185 256**

(73) Proprietor: **Hitachi, Ltd.**
**5-1, Marunouchi 1-chome**
**Chiyoda-ku Tokyo 100 (JP)**

(72) Inventor: **Umeda, Jun-Ichi**
**612-10, Kamiichibukatamachi**
**Hachioji-shi Tokyo (JP)**
Inventor: **Nakashima, Hisao**
**5-1-10-103, Nakaarai**
**Tokorozawa-shi Saitama-ken (JP)**
Inventor: **Kajimura, Takashi**
**2-34-A402, Koyasu-cho**
**Hachioji-shi Tokyo (JP)**
Inventor: **Kuroda, Takao**
**4-14-6, Nishi-koigakubo**
**Kokubunji-shi Tokyo (JP)**

(74) Representative: **Paget, Hugh Charles Edward et al**
**MEWBURN ELLIS & CO. 2/3 Cursitor Street**
**London EC4A 1BQ (GB)**

EP 0 064 339 B1

## Description

The present invention relates to the structure of a semiconductor laser device.

When producing a semiconductor laser with a high optical output, it is indispensible from the standpoint of practical use that the laser beam has optical properties permitting condensing or collimation to the diffraction limitation.

In a semiconductor laser device having the ordinary double-heterostructure, it has been proposed to increase the optical output of the whole device by juxtaposing a plurality of emission portions arranged as strips. The proposal is described in, for example, Appl. Phys. Lett. 34(2), 15 January 1979, pp. 162—165. In actuality, however, the modes, wavelengths, and phases of the laser beams are different in the respective strips, and there has not been obtained a laser beam of high quality which is suitable for optical communication, an optical disk memory, a laser printer or the like.

A semiconductor laser device is known from EP—A—0010949 having a semiconductor assembly for optical confinement including an active layer, cladding layers and electrodes. Cleaving of the ends of semiconductor crystal causes the ends to act as an optical resonator. Furthermore, on one side of the active layer, impurity regions may be provided which generate a plurality of lasing regions in the active layer such that there is a non-linear coupling between adjacent lasing regions, the impurity regions causing a variation of the complex-refractive index in a direction transverse to the direction of traval of the resultant laser beams.

However, in EP—A—0010949 the impurity regions act as current confining means which determines the injected charge distribution and so charges the refractive index. This causes the lasing regions to be located on the perpendiculars from the impurity regions to the plane of the active layer i.e. the lasing regions are directly between the active layer and the impurity regions. Thus, when the emission facet of the laser is viewed in the direction of laser radiation, a plurality of principal emission regions are observed. Such a laser device is known on a 'phase-locked semiconductor laser'. Since the laser beams from the plurality of emission points are photo-coupled with each other the whole optical output has a coherent wavelength and phase in this phase-locked semiconductor laser, and a laser beam of high output capable of condensing and collimation is obtained.

In lasing the radiation distributions of the laser beams oscillating in the active region spread more than the widths of the local emission regions. Accordingly, the intervals of the absorption regions may be made small so that the radiation distributions of the laser beams may be connected with each other to cause the photo-coupling. Thus, the laser oscillations of the respective local emissions may be held at equal wavelengths and in phase.

According to the present invention, however, the regions causing the variation in complex refractive index are optical absorption regions adjacent at least one of the cladding layers, with a different composition from the adjacent cladding layer(s), the composition of the optical absorption regions being selected so that the absorption regions have a higher absorption coefficient than the cladding layers.

Preferably the optical absorption regions are strip-like semiconductor layers parallel to the direction of travel of the laser beams, which layers are cyclically arrayed. Furthermore, the optical absorption regions may be located in the cladding layer on the side of the active layer remote from a substrate on which the semiconductor assembly is constructed.

Embodiments of the invention will now be described, by way of example, with reference to the accompanying drawings, wherein:—

Figure 1 is a perspective view showing an example of a semiconductor laser device according to the present invention,

Figures 2 to 5 are views for explaining the plan arrangements of optical absorption layers, and

Figures 6 to 8 are sectional views showing different examples of the semiconductor laser device of the present invention.

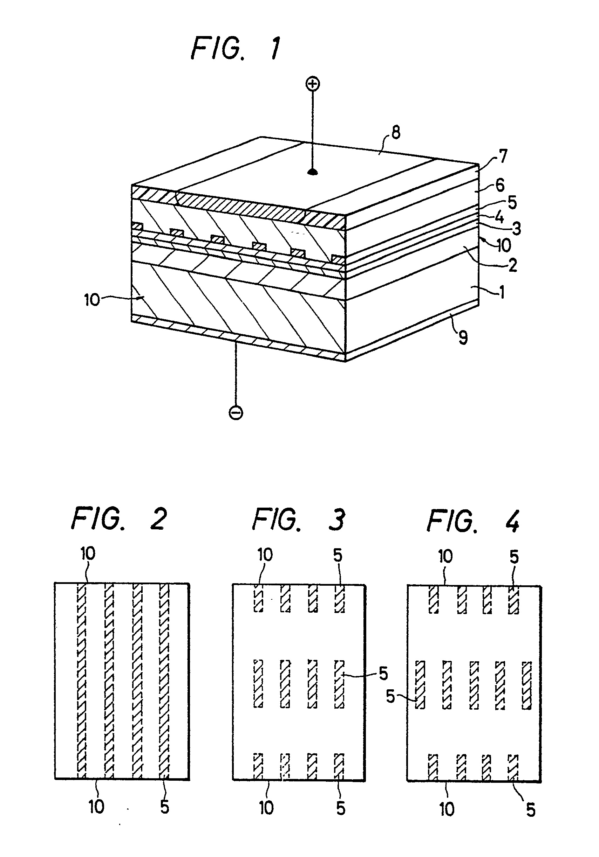

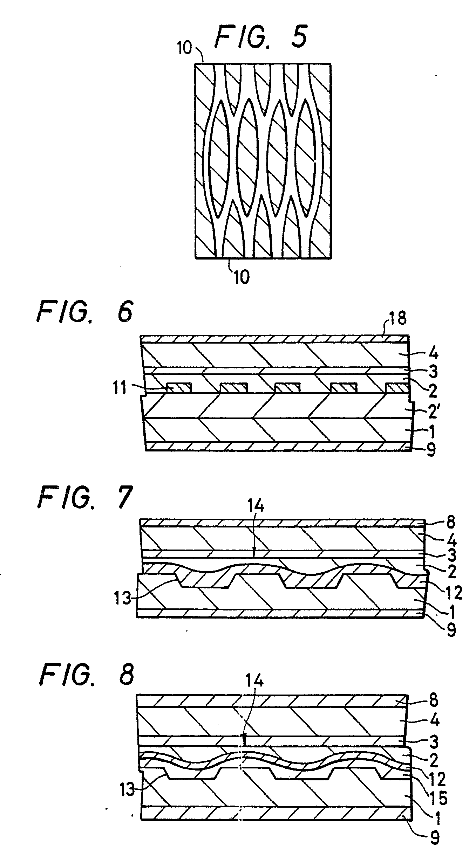

The first embodiment is a striped or islanded optical absorption layer which is parallel to the direction of travel of the laser beam. Examples of this are shown in the perspective view of Figure 1 and plan views of Figures 2—5. The optical absorption layer may be disposed either over the active layer or under the same. A device whose sectional view is shown in Figure 6 is an example in which the optical absorption layer is disposed under the active layer.

Secondly, the optical absorption layer may be formed with uneven parts and disposed over or under the active layer. The distance between the active layer and the optical absorption layer becomes unequal, and substantially no optical absorption takes place in the part of longer distance, whereas optical absorption occurs in the part of shorter distance. Figures 7 and 8 are sectional views of devices showing such examples.

Naturally, other modified embodiments of the present invention are also possible.

Such phase-locked semiconductor laser devices are advantageous in fabrication because the active layer which plays an imporant role for lasing is not processed. Furthermore, a phase-locked semiconductor laser device of low threshold current can be provided.

Hereunder, the present invention will be concretely described in detail in conjunction with embodiments.

Embodiment 1

Figure 1 is a perspective view of a typical semiconductor laser device according to the present invention.

On a predetermined n-type GaAs substrate 1, the following layers are stacked:

(1) n-type $Ga_{1-s}Al_sAs$ layer 2 ($s \geq x+0.3$ where $x$ denotes the mole fraction of AlAs of the active layer; doped with Sn, Te, Se or the like; impurity concentration $n=3 \times 10^{17\pm1}$ cm$^{-3}$; thickness: 1 ($^{+4}_{-0.5}$) μm),

(2) $Ga_{1-x}Al_xAs$ layer 3 ($x=0.15\pm0.15$; thickness: 0.1 ($^{+0.4}_{-0.07}$) μm), and

(3) p-type $Ga_{1-y}Al_yAs$ layer 4 ($y=x+0.4$; thickness: 0.2 ($^{+0.3}_{-0.1}$) θm; doped with Zn, Ge, Mg or the like; impurity concentration $p=3 \times 10^{17\pm1}$ cm$^{-3}$).

The $Ga_{1-s}Al_sAs$ layer 2 and the $Ga_{1-y}Al_yAs$ layer 4 are cladding layers, and the $Ga_{1-x}Al_xAs$ layer 3 is the active layer.

On the $Ga_{1-y}Al_yAs$ layer 4, there is disposed as striped or islanded optical absorption layer 5 which is parallel to the lasing direction. In an example, the optical absorption layer 5 was made of $Ga_{1-z}Al_zAs$ ($0 \leq z < x$) and was 0.3 ($^{+0.7}_{-0.2}$) θm thick. (The dopant of the optical absorption layer is not especially critical). The plan configuration of the striped optical absorption layer is shown in Figure 2, while the plan configurations of the islanded optical absorption layers are shown in Figures 3 and 4. In case of disposing the optical absorption layer in the shape of islands, as shown in Figure 3, the respective islands of the optical absorption layer 5 may be arrayed in the form of a matrix in such a manner that the lengthwise direction of each island is parallel to the lasing direction. Alternatively, as shown in Figure 4, the islands of the optical absorption layer 5 may be arrayed in such a manner that the groups of islands arranged in the widthwise direction thereof are alternately staggered a half pitch in the direction orthogonal to the lasing direction. As shown in Figure 5, the optical absorption layer may well be constructed in the shape of meshes in such a manner that laser beams substantially intersect to form a simply connected net. Further, it is allowed to provide narrow parts and wide parts in the respective islands of the optical absorption layer and to cause photo coupling between laser emission parts proximate to each other.

The width of each constituent of the optical absorption layer is $3\pm2$ μm. The pitch of the strips of the striped optical absorption layer is 10 ($^{+2}_{-9}$) μm, and the pitch-to-width ratio is preferably selected within a range of 3—10. In case of the islanded optical absorption layer, a similar pitch may be selected. As the total length of the optical absorption layer in the lasing direction, approximately 1/2 of the length of the optical resonator (in general, the resonator length is 300 μm$\pm$200 μm) is suitable.

On the optical absorption layer 5, a $Ga_{1-u}Al_uAs$ layer 6 is disposed to a thickness of 1 ($^{+4}_{-0.5}$) μm. This layer 6 may be fundamentally the same as the foregoing layer 4, but the mole fraction of AlAs, the carrier concentration etc. of the former may well be somewhat lower than those of the latter.

The various semiconductor layers mentioned above are formed by the well-known liquid phase epitaxial method. The processing, such as etching, of the semiconductor layers is satisfactorily carried out with any hitherto known method.

It is a matter of course that the well-known vapor phase epitaxial method, molecular beam epitaxial method etc. may well be used in forming the semiconductor layers.

On the layer 6, a metal layer 8 made of Cr—Au is formed as a region for injecting current, while on the rear surface of the GaAs substrate 1, a metal layer made of an Au—Ge alloy is formed as an electrode 9. Lastly, the crystal is cleaved along planes 10 perpendicular to the direction of travel of the laser beam so as to construct the optical resonator. Numeral 7 in Figure 1 indicates an insulator layer.

A GaAs layer (for example, made of p-type GaAs, doped with Zn and having an impurity concentration of $1 \times 10^{18}$ cm$^{-3}$) is often formed as a cap layer on the semiconductor layer 4. A thickness of approximately 0.5 μm is sufficient therefor. Although there can be modifications in which further semiconductor layers are disposed, such measures are not pertinent to the essentials of the present invention.

In an example, the oscillation characteristics of a semiconductor laser device in which the optical absorption layer 5 was formed as shown in Figure 2 were as stated below. The resonator had a length of 300 μm and a width of 300 μm, and the number of emission strips was 30. The oscillation wavelength was 760 nm, the threshold current value was 2.7 A, and the maximum optical output was 1.5 W at a voltage of 3 V and a current of 4.2 A. The spread angle of an emergent beam was about 1° within both the surfaces of the active layer, and the perpendicular direction was about 30°. Using two cylindrical lenses, the emergent beam could be collimated and condensed to the diffraction limitation.

Embodiment 2

This embodiment is an example in which an optical absorption layer is disposed on the substrate side. Figure 6 is a sectional view of the semiconductor laser device seen from the facet of the optical resonator.

On a predetermined n-type GaAl substrate 1, an n-type $Ga_{1-s}Al_sAs$ layer 2' is formed to a thickness of about 1 μm. On the layer 2', a $Ga_{1-z}Al_zAs$ ($0 \leq z \leq x$) layer to become the optical absorption layer is formed to a thickness of 0.3 μm. Using the well-known etching, techniques, the $Ga_{1-z}Al_zAs$ layer is processed into the construction of the optical absorption layer shown in Fig. 2. The width of each strip of the optical absorption layer 11 is 3 μm, and the pitch of the strips is 10 μm. On the optical absorption layer, an n-type $Ga_{1-s}Al_sAs$ layer 2 is formed again, and it is overlaid with a non-doped $Ga_{1-x}Al_xAs$ layer 3 and a p-type $Ga_{1-y}Al_yAs$ layer 4. Excepting the thicknesses, the compositions etc. of the respective GaAlAs layers are the same as in the case of Embodiment 1. The $Ga_{1-s}Al_sAs$ layer 2 is made 0.2 ($^{+0.3}_{-0.1}$) μm thick

between the $Ga_{1-x}Al_xAs$ layer 3 (which is the active layer) and the optical absorption layer 11.· The $Ga_{1-x}Al_xAs$ layer 3 is 0.1 ($\pm^{0.4}_{0.07}$) μm thick, and the $Ga_{1-y}Al_yAs$ layer 4 is 1 μm thick. As in Embodiment 1, a cap layer is appropriately· disposed on the layer 4.

Numerals 18 and 9 in Figure 6 designate electrodes on the + side and − side, respectively, and these electrodes are similar to those of Embodiment 1. The construction of the optical resonator is also similar.

With the present structure, oscillation characteristics similar to those of Embodiment 1 were obtained.

Embodiment 3

This embodiment illustrates another example in which an optical absorption layer is disposed on the substrate side. Figure 7 is a sectional view of the semiconductor laser device seen from the facet of the optical resonator.

In the surface of an n-type GaAs substrate 1, a plurality of grooves 13 are provided in parallel with the direction of lasing. The width of each groove is 4 μm, the pitch of the grooves is 7 ($\pm^{3}_{6}$) μm, and the depth of the groove is 1 ($\pm^{1}_{0.5}$) μm. On the grooved n-type GaAs substrate 1, a corrugated n-type $Ga_{1-z}Al_zAs$ layer 12 ($0-\leq z\leq x$; $n=3\times10^{17\pm1}$ $cm^{-3}$; its dopant being Sn, Te, Se or the like) which serves as the optical absorption layer is provided along the shape of the grooves. Further, an n-type $Ga_{1-s}Al_sAs$ layer 2 ($s\geq x+0.3$; $n=3\times10^{17\pm1}$ $cm^{-3}$; its dopant being Se, Te or Se) is formed. The thickness of the thinnest part 14 (over a part corresponding to the crest of the corrugated layer 12) of the n-type $Ga_{1-s}Al_sAs$ layer 2 which serves as the cladding layer is made approximately 0.2 ($\pm^{0.3}_{0.1}$) μm. The corrugated semiconductor layer can be readily obtained by selecting the growth conditions of the crystal. The remaining construction is the same as in Embodiment 2.

Optical absorption occurs selectively in the thin parts 14 of the cladding layer 2, and substantially the same effect as in the striped optical absorption layer is achieved. As in Embodiment 1, accordingly, a plurality of emission points and modes can be selected, and photo coupling between laser beams from the adjacent emission points can be realized.

A further example in which the optical absorption layer is disposed on the substrate side is shown in Figure 8. This figure is a sectional view of the semiconductor laser of the example. The optical absorption layer 12 is a wavy thin layer unlike that in the example of Figure 7. The thickness of the optical absorption layer 12 in this example is 0.2 ($\pm^{0.5}_{0.1}$) μm. A semiconductor layer 15 may be made of a material of the same system as the material of the semiconductor layer 2 or the semiconductor layer 12. The function of optical absorption is performed by the semiconductor layer 15. The remaining construction is the same as in the example of Figure 7.

Embodiment 4

While, in the foregoing embodiments, only examples constructed on n-type GaAs substrates have been described, a p-type GaAs substrate may well be used. In this case, the conductivity types of the respective layers may be made the opposite conductivity types to those in the foregoing embodiments.

Needless to say, as regards the semiconductor materials, the present invention is not restricted to semiconductor lasers of the GaAlAs—GaAs system, but it is similarly applicable to semiconductor lasers employing a compound semiconductor of a ternary system such as GaAlP, InGaP, GaAsP or GaAsSb system; a compound semiconductor of a quaternary system such as InGaAsP, GaAlAsSb or GaAlAsP system; etc. Naturally these semiconductor lasers fall within the scope of the present invention.

Examples employing the InP—InGaAsP system materials will be described. The basic structure is the same as in Figure 1.

On an n-type InP substrate 1, the following layers are stacked:

(1) n-type InP layer 2 (doped with Te; impurity concentration: $3.1\times10^{17}$ $cm^{-3}$; thickness: 1 μm),

(2) $In_{0.88}Ga_{0.12}As_{0.23}P_{0.77}$ layer 3 (thickness: 0.15 μm), and

(3) p-type InP layer 4 (doped with Zn; impurity concentration: $3\times10^{17}$ $cm^{-3}$).

The InGaAsP layer 3 is an active layer.

On the p-type InP layer 4, a striped or islanded optical absorption layer 5 parallel to the direction of travel of the laser beam is disposed. The optical absorption layer 5 is made of $In_{0.2}Ga_{0.8}As_{0.5}P_{0.5}$, and is 0.3 μm thick. The plan configurations of the striped and islanded optical absorption layers are the same as in Figures 2—4.

The width of each constituent of the optical absorption layer is $3\pm2$ μm, and the pitch of the strips or islands of the optical absorption layer is 10 ($\pm^{2}_{9}$) μm. The ratio between the pitch and the width is selected within a range of 3—10.

On the optical absorption layer 5, p-type InP layer 6 is disposed to a thickness of 1 μm. This layer 6 may be fundamentally the same as the above layer 4.

Usually, a cap layer is disposed on the layer 6. The cap layer is made of $In_{0.73}Ga_{0.17}As_{0.38}P_{0.62}$. A Cr—Au electrode is used as a plus side electrode 8, while an Au—Sn electrode is used as a minus side electrode 9. Shown at numeral 7 is an insulating layer.

The number of strips is 15, the length of a resonator is 300 μm, and the width of the resonator is 400 μm.

Each semiconductor laser thus prepared exhibited an emission wavelength of 1.3 μm and a threshold current of 2.8 A, and produced a laser beam whose spread angle was about 2—3° within both the surfaces of the active layer and whose perpendicular direction was about 30°.

Claims

1. A semiconductor laser device comprising a semiconductor assembly for optical confinement, which assembly includes an active layer (3) cladding layers (2, 4, 6) electrodes (8, 9), first means (10) forming an optical resonator, and second means (5, 11, 12) on one or other side of the active layer for generating a plurality of lasing regions in the active layer such that there is non-linear coupling between adjacent lasing regions, the second means (5, 11, 12) causing a variation of complex refractive index in a direction transverse to the direction of travel of the resultant laser beams characterised in that:

the second means are optical absorption regions (5, 11, 12) adjacent at least of the cladding layers (2, 4) with a different composition from the adjacent cladding layer(s) (2, 4), the composition of the optical absorption regions being selected so that the absorption regions have a higher absorption coefficient than the cladding layers (2, 4, 6).

2. A device according to claim 1, wherein the optical absorption regions (5, 11) are discretely arranged in the direction transverse to the direction of travel of the laser beams.

3. A device according to claim 1 or claim 2, wherein the optical absorption regions (5, 11) are strip-like semiconductor layers parallel to the direction of travel of the laser beams, which layers are cyclically arrayed.

4. A device according to claim 1 or claim 2, wherein the optical absorption regions (5, 11) are strip-like semiconductor islands parallel to the direction of travel of the laser beams, which islands are cyclically arrayed.

5. A device according to claim 1 or claim 2, wherein the optical absorption regions are formed by a semiconductor material layer (12) in which regions (14) of a shorter distance to the active layer (3) through the semiconductor layer and regions of a longer distance exist alternately in a sectional structure in a plane perpendicular to the direction of travel of the laser beams.

6. A device according to any one of claims 1 to 4 wherein the optical absorption regions (5) are located in the cladding layer (4, 6) on the side of the active layer (3) remote from a substrate (1) on which the semiconductor assembly is constructed.

7. A device according to any one of claims 1 to 5 wherein the optical absorption regions (11, 12) are located in the cladding layer (2) on one side of the active layer (3) closest to a substrate (1) on which the semiconductor assembly is constructed.

## Patentansprüche

1. Halbleiterlaservorrichtung mit einer Halbleiteranordnung für die optische Einschließung, wobei diese Anordnung eine aktive Schicht (3), Überzugsschichten (2, 4, 6), Elektroden (8, 9), eine erste Einrichtung (10) zur Bildung eines optischen Resonators und eine zweite Einrichtung (5, 11, 12) auf der einen oder der anderen Seite der aktiven Schicht aufweist zum Erzeugen einer Anzahl von lasernden Gebieten in der aktiven Schicht derart, daß eine nicht-lineare Kopplung zwischen benachbarten lasernden Gebieten vorhanden ist, und wobei die zweite Einrichtung (5, 11, 12) eine Änderung des komplexen Brechungsindex in einer zur Ausbreitungsrichtung der resultierenden Laserstrahlen senkrechten Richtung verursacht, dadurch gekennzeichnet, daß

die zweite Einrichtung optische Absorptionsgebiete (5, 11, 12) umfaßt, die wenigstens einer der Überzugsschichten (2, 4) benachbart sind und eine zu der bzw. den benachbarten Überzugsschicht(en) (2, 4) verschiedene Zusammensetzung besitzen, wobei die Zusammensetzung der optischen Absorptionsgebiete so gewählt ist, daß die Absorptionsgebiete einen höheren Absorptionskoeffizienten besitzen als die Überzugsschichten (2, 4, 6).

2. Vorrichtung nach Anspruch 1, bei der die optischen Absorptionsgebiete (5, 11) in einer zur Ausbreitungsrichtung der Laserstrahlen senkrechten Richtung diskret angeordnet sind.

3. Vorrichtung nach Anspruch 1 oder 2, bei der die optischen Absorptionsgebiete (5, 11) zur Ausbreitungsrichtung der Laserstrahlen parallel streifenförmige Halbleiterschichten sind, die periodisch angeordnet sind.

4. Vorrichtung nach Anspruch 1 oder 2, bei der die optischen Absorptionsgebiete (5, 11) streifenartige, zu der Ausbreitungsrichtung der Laserstrahlen parallele Halbleiterinseln sind, wobei diese Inseln periodisch angeordnet sind.

5. Vorrichtung nach Anspruch 1 oder 2, bei der die optischen Absorptionsgebiete durch eine Schicht aus Halbleitermaterial (12) gebildet sind, und in einem Querschnittsaufbau, der in einer zur Ausbreitungsrichtung der Laserstrahlen senkrechten Ebene liegt, abwechselnd Gebiete (14) mit einer durch die Halbleiterschicht kürzeren Abstand zur aktiven Schicht (3) und Gebiete mit einem längeren Abstand vorhanden sind.

6. Vorrichtung nach einem der Ansprüche 1 bis 4, bei der die optischen Absorptionsgebiete (5) in der Überzugsschicht (4, 6) auf der Seite der aktiven Schicht (3) und entfernt vom Substrat (1), auf dem de Halbleiteranordnung aufgebaut ist, angeordnet sind.

7. Vorrichtung nach einem der Ansprüche 1 bis 5, bei der die optischen Absorptionsgebiete (11, 12) in der Überzugsschicht (2) an der Seite der aktiven Schicht (3) angeordnet sind, die dem Substrat (1), auf dem die Halbleiteranordnung aufgebaut ist, am nächsten ist.

## Revendications

1. Dispositif laser à semiconducteurs comprenant un ensemble semiconducteur servant à réaliser un confinement optique, lequel ensemble comporte une couche active (3), des couches de revêtement (2, 4, 6), des électrodes (8, 9), des premiers moyens (10) formant un résonateur optique et des seconds moyens (5, 11, 12) situés sur l'une ou l'autre face de la couche active de manière à produire une pluralité de régions fournissant l'effet laser dans la couche active de telle sorte qu'il existe un couplage non linéaire entre des régions voisines fournissant l'effet laser, les seconds moyens (5, 11, 12) produisant une variation de l'indice de réfraction complexe suivant une direction transversale par rapport à la direction de propagation des faisceaux laser obtenus, caractérisé en ce que:

les seconds moyens sont des régions d'absorption optique (5, 11, 12) voisines d'au moins l'une des couches de revêtement (2, 4) et possédant une composition qui diffère de celle de la ou des couches de revêtement voisines (2, 4), la composition des régions d'absorption optique étant choisie de telle sorte que les régions d'absorption possèdent un coefficient d'absorption plus élevé que les couches de revêtement (2, 4, 6).

2. Dispositif selon la revendication 1, dans lequel les régions d'absorption optique (5, 11) sont disposées de façon discrète suivant la direction transversale par rapport à la direction de propagation des faisceaux laser.

3. Dispositif selon la revendication 1 ou 2, dans lequel les régions d'absorption optique (5, 11) sont des couches semiconductrices en forme de bandes parallèles à la direction de propagation des faisceaux laser, lesquelles couches sont disposées de manière cyclique.

4. Dispositif selon la revendication 1 ou 2, dans lequel les régions d'absorption optique (5, 11) sont des îlots semiconducteurs en forme de bandes parallèles à la direction de déplacement des faisceaux laser, lesquels îlots sont disposés de manière cyclique.

5. Dispositif selon la revendication 1 ou 2, dans lequel les régions d'absorption optique sont formées par une couche (12) d'un matériau semiconducteur, dans laquelle des régions (14) situées à une courte distance de la couche active (3) travers la couche semiconductrice et des régions situées à une distance plus importante de la couche active existent en alternance dans une structure prise en coupe dans un plan perpendiculaire à la direction de propagation des faisceaux laser.

6. Dispositif selon l'une quelconque des revendications 1 à 4, dans lequel les régions d'absorption optiques (5) sont situées dans la couche de revêtement (4, 6) sur le côté de la couche active (3), qui est éloigné d'un substrat (1) sur lequel l'ensemble semiconducteur est construit.

7. Dispositif selon l'une quelconque des revendications 1 à 5, dans lequel les régions d'absorption optique (11, 12) sont situées dans la couche de revêtement (2), sur un côté de la couche active (3), qui est le plus rapproché d'un substrat (1) sur lequel l'ensemble semiconducteur est construit.

FIG. 1

FIG. 2    FIG. 3    FIG. 4

## FIG. 5

## FIG. 6

## FIG. 7

## FIG. 8